# EUROPEAN PATENT APPLICATION

(11) **EP 4 019 254 A1**
(43) Date of publication of application: **29.06.2022**
(21) Application number: 20858037.3
(22) Date of filing: 30.07.2020
(51) Int. Cl.: B41C 1/00, B41N 1/12, B41M 1/04, G03F 7/00, G03F 7/027, G03F 7/033, G03F 7/095, G03F 7/11

(54) **FLEXOGRAPHIC PRINTING ORIGINAL PLATE**

(30) Priority: 23.08.2019 JP 2019152853
(71) Applicant: TOYOBO CO., LTD., Osaka-shi Osaka 5300001 (JP)
(72) Inventor: YOSHIMOTO, Kazuya, Okayama-shi, Okayama 704-8194 (JP); HIGO, Eri, Otsu-shi, Shiga 520-0292 (JP); NAKAMORI, Masahiko, Okayama-shi, Okayama 704-8194 (JP)
(74) Representative: Müller-Boré & Partner Patentanwälte PartG mbB
(86) International application number: PCT/JP2020/029213
(87) International publication number: WO 2021/039263

(57) **Abstract**

The present invention provides a flexographic printing plate precursor which makes it possible to precisely reproduce the pattern of a microcell on the surface of a printing plate without requiring the use of any specialized device or any additional step, and thus to improve the ink laydown on a solid-printed part. A flexographic printing plate precursor comprising at least a support (A), a photosensitive resin layer (B), an oxygen barrier layer (C) and a heat-sensitive mask layer (D) which are laminated in this order, wherein a photosensitive resin composition constituting the photosensitive resin layer (B) comprises (a) a polymer prepared by polymerizing a conjugated diene, (b) an ethylenically unsaturated compound and (c) a photopolymerization initiator, and wherein the content of the photopolymerization initiator (c) in the photosensitive resin composition is 2 to 9% by mass.

## Description

### Technical Field

The present invention relates to a flexographic printing plate precursor which is excellent in reproducibility of a microcell on a solid-printed part of a printing plate and excellent in ink laydown on a solid-printed part.

### Background Art

Flexographic printing is a printing method in which an ink is applied onto convex parts on a printing plate and then the printing plate is pressed against a substrate so as to transfer the ink from the printing plate to the substrate. A printing plate used in flexographic printing is relatively soft and can fit to various shapes, and therefore makes it possible to print on wide varieties of substrates. Examples of the substrate include a packaging film, label paper, drink carton, a paper-made container, an envelope and cardboard. Particularly for a substrate having a rough surface, flexographic printing is mainly employed. Furthermore, flexographic printing can utilize a water-based or alcohol-based ink from which the emission amount of VOCs (volatile organic compounds) is small. Therefore, flexographic printing is a highly environment-friendly printing method. Due to the above-mentioned advantages, i.e., the adaptability to substrates and the environmental friendliness, gravure printing and offset printing are increasingly shifting to flexographic printing.

Meanwhile, flexographic printing has a disadvantage that the ink laydown on a solid-printed part is inferior in the printing on a film substrate compared with gravure printing. As to one method for improving the ink laydown on a solid-printed part in flexographic printing, a method is known in which a physical pressing pressure between a printing plate and an object to be printed is increased. In this case, however, fine dots are deformed by the action of the pressing pressure and the printability of the fine dots is deteriorated.

As to another method, a method is known in which a microcell is provided on the surface of a solid-printed part to improve the ink laydown on the solid-printed part. The term "microcell" refers to a specific fine concave-convex pattern formed on a surface of a solid-printed part. When the microcell is provided, proper movability can be imparted to the ink upon the pressing of the printing plate against the object to be printed, whereby the uniformity of distribution of the ink on the solid-printed part can be improved. As to a method for providing a microcell on a solid-printed part in a printing plate, a method in which a microcell is imaged on the solid-printed part in a heat-sensitive mask layer and the image is reproduced on the printing plate has been widely employed. A typical example of this method is microcell screening by ESKO-Graphic Corporation (see Non-Patent Document 1). Examples of the type of the microcell screening include an MC type in which a rectangular cell is introduced, a GROOVY type in which a diagonal stroke-like microcell is introduced, and a single pixel screen in which a cell having a specialized shape is introduced. For utilizing these microcells effectively, it is required to precisely reproduce a microcell drawn on the heat-sensitive mask layer on a solid-printed part in a printing plate.

In order to precisely reproduce the pattern of a microcell on the surface of a printing plate, it is important to suppress the oxygen-induced polymerization inhibition in a photosensitive resin layer. When the photosensitive resin layer undergoes oxygen-induced polymerization inhibition, the crosslinking reaction in the photosensitive resin layer does not proceed fully. Accordingly, the surface of the photosensitive resin layer is washed out in a developing step, and therefore the pattern of the microcell cannot be precisely reproduced.

For solving these problems, Patent Document 1 proposes a method in which a printing plate is exposed to light under an inert gas atmosphere to suppress the oxygen-induced polymerization inhibition, whereby the pattern of the microcell is reproduced precisely on the surface of the printing plate. In this method, however, there is the problem that a specialized device is needed for the exposure to light under an inert gas atmosphere. Patent Document 2 proposes a method in which an oxygen barrier layer is laminated on a mask layer after having been subjected to the imaging so as to suppress the oxygen-induced polymerization inhibition, whereby the pattern of the microcell is reproduced precisely on the surface of the printing plate. In this method, however, there is the problem that a dedicated laminator is needed for the lamination of the oxygen barrier layer on the mask layer after the imaging, and there is also the problem that a printing plate production process becomes complicated. Patent Documents 3 and 4 propose a printing plate precursor in which an oxygen barrier layer is provided between a photosensitive resin layer and a heat-sensitive mask layer so as to suppress an oxygen-induced polymerization inhibition. These methods are advantageous in that any specialized device or an additional step is not needed in the printing plate production process. These oxygen barrier layers can suppress the oxygen-induced polymerization inhibition to some extent. However, the crosslinking reaction does not proceed fully and therefore the pattern of a microcell cannot be reproduced precisely on the surface of the printing plate.

### Prior Art Documents

### Patent Documents

Patent Document 1: Japanese Patent No. 6219954
Patent Document 2: Japanese Patent No. 5872693
Patent Document 3: Japanese Patent No. 5573675
Patent Document 4: Japanese Patent No. 4332865

### Non-Patent Documents

Non-Patent Document 1: Journal of printing science and technology, vol. 43, No. 4 (2006), pp. 261-271.

### Disclosure of the Invention

### Problem that the Invention is to Solve

The present invention has been made in the above-mentioned situations of the prior art techniques. The object of the present invention is to provide a flexographic printing plate precursor which makes it possible to precisely reproduce the pattern of a microcell on the surface of a printing plate without requiring the use of any specialized device or any additional step, and thus to improve the ink laydown on a solid-printed part.

### Means for Solving the Problem

The present inventors have made extensive and intensive studies for the purpose of achieving the above-mentioned object. As a result, it was found that, by providing an oxygen barrier layer of the same type as those disclosed in Patent Documents 3 and 4 between a photosensitive resin layer and a heat-sensitive mask layer and by increasing the content of a photopolymerization initiator in the photosensitive resin layer compared with the conventional flexographic printing plate precursor, the crosslinking reaction in the photosensitive resin can proceed fully without being affected by the oxygen-induced polymerization inhibition during exposure, particularly main exposure, whereby a microcell pattern imaged on the heat-sensitive mask layer can be reproduced precisely on the printing plate. These findings lead to the accomplishment of the present invention.

In summary, the present invention has the following configurations (1) to (6).
(1) A flexographic printing plate precursor comprising at least a support (A), a photosensitive resin layer (B), an oxygen barrier layer (C) and a heat-sensitive mask layer (D) which are laminated in this order, wherein a photosensitive resin composition constituting the photosensitive resin layer (B) comprises (a) a polymer prepared by polymerizing a conjugated diene, (b) an ethylenically unsaturated compound and (c) a photopolymerization initiator, and wherein the content of the photopolymerization initiator (c) in the photosensitive resin composition is 2 to 9% by mass.
(2) The flexographic printing plate precursor according to (1), wherein the ethylenically unsaturated compound (b) includes a (meth)acrylate compound (i) having a number average molecular weight of 100 to 600, wherein the content of the (meth)acrylate compound (i) having a number average molecular weight of 100 to 600 in the photosensitive resin composition is 5 to 16% by mass, and wherein the ratio of the mass of the photopolymerization initiator (c) to the mass of the (meth)acrylate compound (i) having a number average molecular weight of 100 to 600 in the photosensitive resin composition is within the range of 0.20 to 0.55.
(3) The flexographic printing plate precursor according to (2), wherein the ethylenically unsaturated compound (b) further includes a (meth)acrylate compound (ii) having a number average molecular weight of more than 600 and not more than 20,000, and wherein the content of the (meth)acrylate compound (ii) having a number average molecular weight of more than 600 and not more than 20,000 in the photosensitive resin composition is 5 to 25% by mass.
(4) The flexographic printing plate precursor according to any of (1) to (3), wherein the development is performed by using a water-based developing solution.
(5) A flexographic printing plate obtained by exposing and developing the flexographic printing plate precursor of any of (1) to (4), characterized in that a microcell is applied to a solid-printed part formed on the printing plate.
(6) A flexographic printing method, characterized in that the method uses the flexographic printing plate according to (5).

### Advantages of the Invention

In the flexographic printing plate precursor according to the present invention, an oxygen barrier layer is provided between a photosensitive resin layer and a heat-sensitive mask layer and the content of a photopolymerization initiator in the photosensitive resin composition is increased compared with the conventional flexographic printing plate precursor. Therefore, a microcell pattern can be reproduced precisely on the surface of a printing plate without requiring the use of any specialized device or any additional step and without being affected by the oxygen-induced polymerization inhibition during exposure, particularly main exposure. As a result, the ink laydown on a solid-printed part in the printing plate can be improved.

### Best Mode for Carrying Out the Invention

The flexographic printing plate precursor according to the present invention is a flexographic printing plate precursor comprising at least a support (A), a photosensitive resin layer (B), an oxygen barrier layer (C) and a heat-sensitive mask layer (D) which are laminated in this order, wherein a photosensitive resin composition constituting the photosensitive resin layer (B) comprises (a) a polymer prepared by polymerizing a conjugated diene, (b) an ethylenically unsaturated compound and (c) a photopolymerization initiator, wherein the content of the photopolymerization initiator (c) in the photosensitive resin composition is 2 to 9% by mass. In this way, by providing an oxygen barrier layer between a photosensitive resin layer and a heat-sensitive mask layer and by increasing the content of a photopolymerization initiator in the photosensitive resin composition compared with the conventional flexographic printing plate precursor, a microcell pattern can be reproduced precisely on the surface of a printing plate without requiring the use of any specialized device or any additional step and without being affected by the oxygen-induced polymerization inhibition during exposure, particularly main exposure. As a result, the ink laydown on a solid-printed part in the printing plate can be improved. The flexographic printing plate precursor according to the present invention also makes it possible to reproduce an imaged pattern of the heat-sensitive mask layer precisely on the printing plate even when a microcell is introduced to a highlight special dot or a dot, as well as the introduction of a microcell into a solid-printed part. Examples of the highlight special dot include "SambaFlex Screen", "PerfectHighlight Screens", "Smooth PerfectHighlight" and "Support dot" manufactured by ESKO Corporation, in which the number of highlight dots is adjusted. An example of the introduction of a microcell into a dot is "Crystal Screening" manufactured by ESKO Corporation.

The (A) support used in flexographic printing plate precursor is preferably made from a material being flexible and having a superior dimension stability. Examples thereof include: a support made of metal, such as steel, aluminum, copper and nickel, and a support made of a thermoplastic resin, such as a polyethylene terephthalate film, a polyethylene naphthalate film, a polybutylene terephthalate film and a polycarbonate film. Among these, the polyethylene terephthalate film, which has the superior dimension stability and a sufficiently high viscoelasticity, is in particular preferably used. A thickness of the support is set to 50 to 350 µm, preferably, to 100 to 250 µm, from viewpoints of mechanical properties, shape stability and handling characteristics during manufacturing of a printing plate. Moreover, if necessary, an adhesive may be arranged between the support (A) and the photosensitive resin layer (B) in order to improve an adhesive property between them.

The photosensitive resin composition constituting the photosensitive resin layer (B) used in flexographic printing plate precursor comprises (a) a polymer prepared by polymerizing a conjugated diene, (b) an ethylenically unsaturated compound and (c) a photopolymerization initiator, and if necessary, comprises an additive such as a plasticizer, a hydrophilic compound, an ultraviolet ray absorber, a surface tension modulator, a thermal polymerization inhibitor, a dye, a pigment, a flavoring agent, and an antioxidant agent. The present invention is particularly characterized in that: in the photosensitive resin composition constituting the photosensitive resin layer (B), the composition of the ethylenically unsaturated compound (b) is specifically designed; and the photopolymerization initiator (c) is used at a mass-based ratio that is larger than the ratio actually employed in the conventional techniques.

As to the polymer prepared by polymerizing the conjugated diene (a), a conventional known synthetic high-molecular-weight compound that has been used in a printing plate precursor can be used. Examples of the polymer include a polymer prepared by polymerizing a conjugated diene hydrocarbon and a copolymer prepared by copolymerizing a conjugated diene hydrocarbon and a monoolefin unsaturated compound. Specific examples of the polymer include a butadiene polymer, an isoprene polymer, a chloroprene polymer, a styrene-butadiene copolymer, a styrene-butadiene-styrene copolymer, a styrene-isoprene copolymer, a styrene-isoprene-styrene copolymer, a styrene-chloroprene copolymer, an acrylonitrile-butadiene copolymer, an acrylonitrile-isoprene copolymer, a (methyl methacrylate)-butadiene copolymer, a (methyl methacrylate)-isoprene copolymer, an acrylonitrile-butadiene-styrene copolymer, and an acrylonitrile-isoprene-styrene copolymer. Among these polymers, a butadiene polymer is preferably used, from the viewpoint of the properties of flexographic printing plates, i.e., repulsion elasticity of a surface of a printing plate, high elongation properties, resin plate hardness, dimensional stability during unexposed state, and easy availability. These polymers may be used singly, or two or more of them may be used in combination. It is preferred that the content of the component (a) in the photosensitive resin composition that forms the photosensitive resin layer (B) is within the range of 40 to 70% by mass.

As to the ethylenically unsaturated compound (b), a conventional known one that has been used in a printing plate precursor can be used. It is preferred to include a (meth)acrylate compound having a number average molecular weight of 100 to 600 (hereinafter, it may be simply referred to as a (meth)acrylate compound having a low molecular weight) (i). In addition, it is preferred to further include a (meth)acrylate compound having a number average molecular weight of more than 600 and not more than 20,000 (hereinafter, it may be simply referred to as a (meth)acrylate compound having a high molecular weight) (ii). The (meth)acrylate compound having a low molecular weight is crosslinked and cured by the action of a photopolymerization initiator so as to form a dense crosslinked network. The (meth)acrylate compound having a high molecular weight is crosslinked and cured by the action of the photopolymerization initiator so as to form a loose crosslinked network. The number average molecular weight of the former is further preferably 200 to 500, and that of the latter is further preferably 2000 to 10000. As mentioned above, when not only the (meth)acrylate compound having a low molecular weight but also the (meth)acrylate compound having a high molecular weight are contained, the reproducibility of isolated dots and durability during printing cannot be deteriorated even when the photopolymerization initiator (c) is added in a larger amount compared with the conventional flexographic printing plate. This is supposed to be because the toughness of the printing plate is increased by the addition of the (meth)acrylate compound having a high molecular weight in a specified amount. It is preferred that the content of the component (b) in the photosensitive resin composition that forms the photosensitive resin layer (B) is within the range of 10 to 50% by mass.

The content of the (meth)acrylate compound having a high molecular weight in the photosensitive resin composition is preferably 5 to 25% by mass and further preferably 8 to 20% by mass. If the content is less than the above-mentioned range, the durability may be deteriorated when the photopolymerization initiator (c) is added in a larger amount. If the content is more than the above-mentioned range, the composite elastic modulus of a solid-printed part may be increased, whereby the ink laydown on a solid-printed part may become insufficient, which may result in a poor quality of printed matters. The content of the (meth)acrylate compound having a low molecular weight in the photosensitive resin composition is preferably 5 to 16% by mass and further preferably 7 to 13% by mass. When the content of the (meth)acrylate compound having a low molecular weight is less than the above-mentioned range, the oxygen-induced polymerization inhibition may not be fully suppressed. When the content is more than the above-mentioned range, the plate may become to hard, whereby the ink laydown on a solid-printed part may become insufficient, which may result in a poor quality of printed matters.

The (meth)acrylate compound having a low molecular weight is not particularly limited, as long as the number average molecular weight of the compound is within the range of 100 to 600 inclusive. Examples of the compound include liner, branched or cyclic monofunctional monomers such as hexyl (meth)acrylate, nonane (meth)acrylate, lauryl (meth)acrylate, stearyl (meth)acrylate, 2-ethyl, 2-butylpropanediol (meth)acrylate, hydroxyethyl (meth)acrylate, 2-(meth)acryloyloxyethyl hexahydrophtalate, 2-(meth)acryloyloxyethyl phtalate, a (meth)acrylic acid dimer, ECH denatured allyl acrylate, benzyl acrylate, caprolactone (meth)acrylate, dicyclopentenyl (meth)acrylate, isobornyl (meth)acrylate and cyclohexyl (meth)acrylate. The examples also include linear branched or cyclic polyfunctional monomers such as hexanediol di(meth)acrylate, nonanediol di(meth)acrylate, 2-butyl-2-ethylpropanediol di(meth)acrylate, neopentyl glycol di(meth)acrylate, neopentylglycol hydroxypivalate di(meth)acrylate, ECH denatured phthalic acid di(meth)acrylate, dicyclopentadiene di(meth)acrylate, tricyclodecanedimethanol di(meth)acrylate, trimethylolpropane tri(meth)acrylate, pentaerythritol tri(meth)acrylate, ECH denatured glycerol tri(meth)acrylate, trimethylolpropane benzoate (meth)acrylate, EO(PO) denatured trimethylolpropane tri(meth)acrylate and dipentaerythritol hexa(meth)acrylate. These compounds may be used singly. Alternatively, two or more of them may be used in combination for the purpose of imparting a desired resin property.

The (meth)acrylate compound having a high molecular weight is not particularly limited, as long as the number average molecular weight of the compound is within the range of more than 600 and not more than 20,000. For example, a butadiene oligomer or an isoprene oligomer each having a (meth)acrylate group attached thereto, and urethane(meth)acrylate are also exemplified. These compounds may be used singly. Alternatively, two or more of them may be used in combination for the purpose of imparting a desired resin property.

The ratio of the mass of the photopolymerization initiator (c) to the mass of the (meth)acrylate compound (i) having a low molecular weight [(mass of the photopolymerization initiator)/(mass of the (meth)acrylate compound having a low molecular weight)] is preferably 0.20 to 0.55. It is more preferably 0.22 to 0.50 and further preferably 0.25 to 0.45. By adjusting the ratio to a value within such range, the oxygen-induced polymerization inhibition can be suppressed, and thus the pattern of the microcell can be reproduced precisely. If the ratio is less than the above-mentioned range, the content of the photopolymerization initiator is too small and therefore the oxygen-induced polymerization inhibition cannot be suppressed fully. As a result, the crosslinking reaction does not proceed and therefore the pattern of a microcell cannot be reproduced on the printing plate precisely. If the ratio is more than the above-mentioned range, the content of the photopolymerization initiator is too large in relation to the content of the (meth)acrylate, and therefore the amount of the (meth)acrylate involved in the crosslinking reaction may become insufficient. In this case, the oxygen-induced polymerization inhibition cannot be reduced fully, either.

Examples of the photopolymerization initiator (c) include a benzophenone compound, a benzoin compound, an acetophenone compound, a benzyl compound, a benzoin alkyl ether compound, a benzyl alkyl ketal compound, an anthraquinone compound and a thioxanthone compound. More specific examples include benzophenone, chlorobenzophenone, benzoin, acetophenone, benzyl, benzoin methyl ether, benzoin ethyl ether, benzoin isopropyl ether, benzoin isobutyl ether, benzyl dimethylketal, benzyl diethylketal, benzyl diisopropylketal, anthraquinone, 2-ethylanthraquinone, 2-methylanthraquinone, 2-allylanthraquinone, 2-chloroanthraquinone, thioxanthone and 2-chlorothioxanthone.

In the present invention, the content of the photopolymerization initiator (c) in the photosensitive resin composition is preferably 2 to 9% by mass, more preferably 2.5 to 7.5% by mass, and further preferably 3 to 7% by mass. As mentioned above, by increasing the content of the photopolymerization initiator to a larger amount compared with the conventional flexographic printing plate precursor, it becomes possible to fully proceed the crosslinking reaction while completely eliminating the influence of the oxygen-induced polymerization inhibition during exposure to light. As a result, the pattern of the microcell which has been imaged on the heat-sensitive mask layer can be reproduced precisely on the printing plate.

In general, when a flexographic printing plate is produced from a flexographic printing plate precursor, four types of exposure, i.e., back exposure, main exposure, finishing exposure and the exposure with a germicidal lamp, are performed. Back exposure is performed for irradiating the whole area with light from the support side so as to form a floor part on the printing plate. Main exposure is performed for imagewise-irradiating a flexographic printing plate precursor with light through a mask and then crosslinking and curing an unsaturated compound in a light-irradiated part on the photosensitive resin layer, thereby forming an area that will become an image. Finishing exposure is performed for irradiating, with light, the whole are of the printing plate which has been developed after the main exposure and now has convex parts that correspond to the dot part and solid-printed parts formed thereon. The role of finishing exposure is to compensate the insufficient crosslinking and curing by the main exposure and to crosslink and cure side surfaces of the convex of the dot part. Exposure with a germicidal lamp is performed for removing the surface stickiness of the printing plate, and partially has a role of crosslinking and curing of side surfaces of the convex of the dot part, similar to the finishing exposure. In general, each of main exposure and finishing exposure is performed utilizing UVA, while exposure with a germicidal lamp is performed utilizing UVC.

These four types of exposure methods are generally performed under atmosphere. Therefore, inhibition of polymerization by the action of oxygen in the atmosphere occurs. Therefore, conventionally, the crosslinking reaction in the photosensitive resin layer cannot proceed fully. Accordingly, the surface of the photosensitive resin layer is washed out in a developing step, and therefore the pattern of the microcell cannot be precisely reproduced on the surface of a printing plate. In the present invention, in contrast, by adding the photopolymerization initiator in a larger amount compared with the conventional flexographic printing plate precursor, the influence of the inhibition of polymerization by oxygen can be suppressed so as to allow the crosslinking reaction to proceed fully, and thus the imaged pattern (microcell pattern) in the heat-sensitive mask layer can be reproduced precisely on the printing plate.

If the content of the photopolymerization initiator is less than the above-mentioned preferred range, the crosslinking curing reaction during exposure to light becomes insufficient, and the reproduction of the imaged pattern (microcell pattern) on the printing plate may be insufficient. On the other hand, if the content of the photopolymerization initiator exceeds the above-mentioned preferred range, the reproducibility of isolated dots and the durability of the printing plate may be deteriorated.

Conventionally, it has been believed that, when the content of a photopolymerization initiator is increased, the reach of light in the thickness direction of a printing plate is blocked due to the absorption of light by the photopolymerization initiator after the reaction to thereby deteriorate the reproducibility of isolated dots which is greatly affected by the crosslinking in the thickness direction and deteriorate the durability during printing. For these reasons, conventionally, the content of a photopolymerization initiator in a photosensitive resin composition of about 1% by mass at most has been generally employed in the actual practice. In contrast, in the present invention, by adding a (meth)acrylate compound having a high molecular weight in a specified amount in the photosensitive resin composition, it becomes possible to increase the toughness of a printing plate and to thereby overcome the above-mentioned disadvantages of prior arts (deterioration of reproducibility of isolated dots and deterioration of durability during printing) which occur when a photopolymerization initiator is used in a large amount, and therefore utilize benefit (precise reproduction of the microcell pattern on the printing plate caused by elimination of the influence of the oxygen-induced polymerization inhibition) from the increase in the content of the photopolymerization initiator.

The photosensitive resin composition constituting the photosensitive resin layer (B) used in flexographic printing plate precursor comprises, in addition to (a) a polymer prepared by polymerizing a conjugated diene, (b) an ethylenically unsaturated compound and (c) a photopolymerization initiator, an additive such as a plasticizer, a hydrophilic compound, an ultraviolet ray absorber, a surface tension modulator, a thermal polymerization inhibitor, a dye, a pigment, a flavoring agent, and an antioxidant agent, depending on necessity.

The plasticizer is used for imparting flexibility to the photosensitive resin layer (B) . Examples of the plasticizer include a liquid rubber, an oil, a polyester, and a phosphorus-based compound. Examples of the liquid rubber include liquid polybutadiene, liquid polyisoprene, and a compound prepared by adding a hydroxyl group or a carboxyl group to each of these compounds. Examples of the oil include paraffin, naphthene and an aroma oil. An example of the polyester is an adipic acid-based polyester. An example of the phosphoric acid-based compound is a phosphoric acid ester. Among these compounds, a liquid polybutadiene and a liquid polybutadiene having a hydroxyl group or a carboxyl group attached thereto are preferred from the viewpoint of compatibility with the polymer prepared by polymerizing a conjugated diene. When the development is performed with a water-based developing solution, a liquid polybutadiene having a hydroxyl group or a carboxyl group attached thereto is particularly preferred. The content of the plasticizer in the photosensitive resin composition is preferably 5 to 15% by mass.

The hydrophilic compound is used for improving the developability of the photosensitive resin layer (B) with the water-based developing solution. Examples of the hydrophilic compound include a carboxylic acid, a carboxylic acid salt, a sulfonic acid, a sulfonic acid salt, an acrylic polymer having a hydrophilic group (e.g., a hydroxyl group, an amino group, a phosphate group, an ethylene oxide group, a propylene oxide group), a urethane polymer, a polyamide polymer, and a polyester polymer. In addition, a known surfactant may also be used. Among these compounds, a urethane polymer having a carboxylate group is preferred from the viewpoint of the developability in a water-based developing solution. The content of the hydrophilic compound in the photosensitive resin composition is preferably 1 to 15% by mass.

The surface tension modifier is used for modifying the surface tension of a printing plate. By modifying the surface tension of a printing plate, the ink transfer properties and the clogging with an ink on a printing plate can be modified. Examples of the surface tension modifier include a paraffin oil, a long-chain alkyl compound, a surfactant, a fatty acid amide, a silicone oil, a modified silicone oil, a fluorine compound, and a modified fluorine compound. The content of the surface tension modifier in the photosensitive resin composition is preferably 0.1 to 2% by mass.

The ultraviolet ray absorber is used for improving the exposure latitude of the photosensitive resin layer (B). Examples of the ultraviolet ray absorber include a benzophenone-based compound, a salicylate-based compound, a benzotriazole-based compound, an acrylonitrile-based compound, a metal complex salt-based compound, a hindered amine-based compound, an anthraquinone-based compound, an azo-based compound, a coumarin-based compound, and a furan-based compound. Among these compounds, a benzotriazole-based compound is preferred from the viewpoint of easy availability and exposure latitude. The content of the ultraviolet ray absorber in the photosensitive resin composition is preferably 0.005 to 0.1% by mass.

The oxygen barrier layer (C) to be used in the flexographic printing plate precursor of the present invention is arranged between the photosensitive resin layer (B) and the heat-sensitive mask layer (D) so as to suppress the oxygen-induced polymerization inhibition during main exposure, for ensuring a full curing reaction. The oxygen barrier layer (C) makes it possible to reduce the influence of the oxygen-induced polymerization inhibition during main exposure to some extent. However, only the use of the oxygen barrier layer is insufficient. In the present invention, in addition to the oxygen barrier layer, the photopolymerization initiator (c) is used in a larger amount compared with the conventional flexographic printing plate precursor. As a result, the crosslinking reaction in the photosensitive resin can be achieved fully, and the microcell pattern can be reproduced precisely on the printing plate. Examples of the binder polymer in the barrier layer include polyvinyl alcohol, partially saponified polyvinyl acetate, an alkyl cellulose, a cellulose-based polymer, and polyamide. These polymers may not be always used singly, or a combination of two or more of these polymers may be used. Examples of the binder polymer which are preferred from the viewpoint of oxygen barrier performance include polyvinyl alcohol, partially saponified polyvinyl acetate, and polyamide. By selecting a binder polymer having oxygen barrier performance within a preferred range, it is possible to control the image reproducibility appropriately.

The thickness of the oxygen barrier layer (C) is preferably 0.2 to 3.0 µm and further preferably 0.2 to 1.5 µm. If the thickness is smaller than the above-mentioned range, the oxygen barrier performance may become insufficient and the printing surface of a relief may be roughened. If the thickness is more than the above-mentioned range, the deterioration in reproducibility of a fine line may occur.

As to the heat-sensitive mask layer (D) used in the flexographic printing plate precursor, any conventional one which has been used in a printing plate precursor can be used. For example, the heat-sensitive mask layer is preferably composed of carbon black (which is a material having the function to absorb infrared ray laser so as to convert the absorbed infrared ray laser to heat and the function to block ultraviolet ray), a dispersion binder for carbon black, and a binder polymer capable of forming a coating film. The dispersion binder may double with the binder polymer capable of forming a coating film. Furthermore, an auxiliary component other than the above-mentioned components, e.g., a pigment dispersing agent, a filler, a surfactant and a coating aid, may be contained, as long as the effects of the present invention cannot be deteriorated.

The heat-sensitive mask layer (D) used in the flexographic printing plate precursor of the present invention is preferably developable with water. Examples of the heat-sensitive mask layer (D) include: a heat-sensitive mask layer containing a combination of a polyamide containing a polar group and a butyral resin (Japanese Patent No. 4200510); a heat-sensitive mask layer containing a polymer having the same structure as that of the polymer in the photosensitive resin layer and an acrylic resin (Japanese Patent No. 5710961); and a heat-sensitive mask layer containing an anionic polymer and a polymer having an ester group in a side chain thereof and having a saponification degree of 0 to 90% inclusive (Japanese Patent No. 5525074).

Although a method for producing the flexographic printing plate precursor of the present invention is not particularly limited, it may be produced generally as mentioned below.

Firstly, components of heat-sensitive mask layer (D) such as binder other than the carbon black are dissolved in a suitable solvent, and then the carbon black is dispersed therein so as to prepare a dispersion. Then the dispersion is applied onto a support for the heat-sensitive mask layer (such as a polyethylene terephthalate film). Then the solvent is evaporated therefrom. After that, a component for the oxygen barrier layer (C) is applied thereon whereupon one laminate is prepared. Further, apart therefrom, the photosensitive resin layer (B) is formed on another support (A) by means of application whereupon another laminate is prepared. The prepared two laminates are layered under pressurization and/or heating in such a manner that the photosensitive resin layer (B) adjacently contacts the oxygen barrier layer (C). Incidentally, after completion of the printing plate precursor, the support for the heat-sensitive mask layer functions as a protective film for a surface thereof.

Now, a method for producing a flexographic printing plate from this flexographic printing plate precursor produced as mentioned above will be explained. Firstly, the protective film (if any) is removed from the flexographic printing plate precursor. Thereafter, the heat-sensitive mask layer (D) is imagewise-irradiated with an IR laser so that an image is formed on the photosensitive resin layer (B). Preferable examples of the IR laser include an ND/YAG laser (1064 nm) and a diode laser (for example, 830 nm). A laser system suitable for the Computer to Plate Technique is commercially available, and, for example, CDI (manufactured by Esko-Graphics Co., Ltd.) may be used. This laser system includes a rotation cylinder drum used for holding a printing plate precursor, an IR laser irradiating device and a layout computer. Pattern information is directly transferred from the layout computer to the laser device.

After the pattern information has been imaged in the heat-sensitive mask layer (D), the entire surface of the flexographic printing plate precursor is irradiated with active light rays via the imagewise-mask (main exposure). This process may be carried out with the plate attached to the laser cylinder. Also, it is possible to remove the plate from the laser device, and then to carry out the irradiation process by using a commonly-used irradiation unit having a flat plate shape. Examples of the active light rays include: ultraviolet rays having an emission peak at a wavelength in a range from 330 to 380 nm. Examples of its light source include: an LED, a low-pressure mercury lamp, a high-pressure mercury lamp, a super-high pressure mercury lamp, a metal halide lamp, a xenon lamp, a zirconium lamp, a carbon arc lamp and an ultraviolet-ray fluorescent lamp. Thereafter, the irradiated plate is developed, subjected to finishing exposure, and subjected to exposure with a germicidal lamp whereby the printing plate is obtained. The development step can be performed with a conventional development unit.

When a microcell is applied to a solid-printed part on a printing plate, a proper microcell is selected from various microcells installed in CDI (ESKO Graphics) and then the selected microcell is applied to an image on a computer, and the image is used for imaging onto a heat-sensitive mask layer.

### Examples

As hereunder, the effects of the printing plate precursor of the present invention will be illustrated by referring to the following Examples although the present invention is not limited to those Examples. A term "part(s)" in Examples stand(s) for part(s) by mass. Values shown in Tables which indicate a composition ratio also stand for part(s) by mass.

Evaluation in Examples was done in accordance with the following methods.

### (1) Reproducibility of microcell on printing plate

The surface of a solid-printed part on a printing plate produced in Pattern 1 mentioned below was enlarged at a magnification of x500 with a digital microscope (VHX5000) manufactured by Keyence Corporation, and the enlarged image was evaluated in accordance with the following criteria. The determination was performed using a MG45 microcell pattern at a point at which the microcell pattern was reproduced best among boost values with 10 increments from 50 to 170.
∘∘: The microcell was reproduced precisely and clearly on the surface of the solid-printed part on the printing plate.
∘: The microcell was reproduced on the surface of the solid-printed part on the printing plate.
Δ: The microcell was reproduced only partially on the surface of the solid-printed part on the printing plate.
×: The microcell was not reproduced on the surface of the solid-printed part on the printing plate.

### (2) Ink laydown on solid-printed part

Regarding the flexographic printing plate produced in Pattern 1, ink laydown on a solid-printed part was evaluated using a flexographic printing machine FPR302 (manufactured by MCK Corporation) and using Anilox of 900LPI. As to the ink, an UV ink (product name: FLEXOCURE CYAN (manufactured by Flint)) was used. As to an object to be printed, a polypropylene film (product name: P4256, manufactured by Toyobo Co., Ltd.) was used. The printing speed was 50 m/min. A position in which the printing plate contacted with the object to be printed was defined as zero. The indentation depth in printing was determined as a position at which the indenter was pushed into a depth of 90 µm from the zero position.

The ink hiding rate (ink uniformity) of a printed matter was measured on each of a normal solid-printed part (without application of microcell) and a solid-printed part to which any one of various microcells was applied, by using a digital microscope (VHX5000) manufactured by Keyence Corporation, and the result was expressed in %. The hiding rate of a microcell pattern that showed the highest hiding rate among various microcells was employed as a hiding rate upon application of microcell. A higher ink hiding rate means that the ink was laid-down more uniformly and therefore ink laydown performance was superior. The difference between a hiding rate of the solid-printed part with the application of microcell and a hiding rate of the normal solid-printed part was calculated, and the value obtained was employed as a measure for the improvement in the hiding rate by the application of microcell.

### (3) Reproducibility of isolated dot

The reproducibility of a minimum isolated dot on the printing plate produced in Pattern 2 mentioned below was measured. A minimum isolated dot having a size of 50 µm or less was rated as "oo", a minimum isolated dot having a size of larger than 50 µm and not larger than 100 µm was rated as "o", a minimum isolated dot having a size of larger than 100 µm and not larger than 200 µm was rated as "Δ", and a minimum isolated dot having a size of larger than 200 µm was rated as "×". A smaller size of the reproduced minimum isolated dot means that the reproducibility of an isolated dot was superior.

### (4) Durability of printing plate

Regarding the flexographic printing plate produced in Pattern 2, durability of printing plate was evaluated using a flexographic printing machine FPR302 (manufactured by MCK Corporation) and using Anilox of 900LPI. As to the ink, an UV ink (product name: FLEXOCURE CYAN (manufactured by Flint)) was used. As to an object to be printed, coat paper (product name: Pearl Coat (manufactured by Oji Paper Co., Ltd.)) was used. The printing speed was 50 m/min. A position in which the printing plate contacted with the object to be printed was defined as zero. The indentation depth in printing was determined as a position at which the indenter was pushed into a depth of 150 µm from the zero position. By such a printing method, the flexographic printing plate was subjected to printing at a length of 5,000 m. Dots each having a diameter of 16 µm on the plate after the printing were observed with a microscope. A dot of which the appearance was not changed before and after the printing was rated as "oo", a dot which was slightly abraded only at an edge part was rated as "o", a dot which was partially lack or abraded was rated as "Δ", and a dot which was entirely lack or abraded was rated as "×".

### Example 1

### Preparation of photosensitive resin composition

A butadiene latex (Nipol LX111NF, non-volatile content: 55%, manufactured by Zeon Corporation) (86 parts by mass) that served as the polymer prepared by polymerizing a conjugated diene, an acrylonitrile-butadiene latex (Nipol SX1503, non-volatile content: 42%, manufactured by Zeon Corporation) (24 parts by mass) that served as the polymer prepared by polymerizing a conjugated diene, a polybutadiene-terminal acrylate having a number average molecular weight of 10000 (BAC45, manufactured by Osaka Organic Chemical Industry Ltd.) (15 parts by mass) that served as an ethylenically unsaturated compound, trimethylolpropane trimethacrylate having a number average molecular weight of 338 (Light Ester TMP, manufactured by Kyoeisha Chemical Co., Ltd.) (10 parts by mass) that served as ethylenically unsaturated compound, benzyl dimethylketal (3 parts by mass) that served as a photopolymerization initiator, and a hydrophilic polymer (PFT-4, non-volatile content: 25%, manufactured by Kyoeisha Chemical Co., Ltd.) (20 parts by mass), a butadiene oligomer (B2000, manufactured by Nippon Soda Co., Ltd.) (9.9 parts by mass), a thermal stabilizer (4-methoxyphenol) (0.1 part by mass), and an ultraviolet ray absorber (Tinuvin 326) (0.01 part by mass) that served as auxiliary components were mixed together in a container so as to produce a dope. The dope was charged into a pressurized kneader, and then the solvent was removed under a reduced pressure at 80°C so as to produce a photosensitive resin composition.

### Preparation of flexographic printing plate precursor

Carbon black dispersion (AMBK-8 manufactured by ORIENT CHEMICAL INDUSTRIES CO., LTD.), copolymerized polyamide (PA223 manufactured by TOYOBO CO., LTD.), propylene glycol, and methanol were mixed at a mass proportion of 45/5/5/45 so as to obtain an heat-sensitive mask layer coating solution. After a releasing treatment was performed on both sides of a PET film (E5000 manufactured by TOYOBO CO., LTD., thickness: 100 µm), the heat-sensitive mask layer coating solution was applied onto the PET film using a bar coater so that a thickness of a coating film after being dried was 2 µm, and dried at 120°C for 5 minutes so as to obtain a film laminate (I) . An optical density thereof was 2.3. The optical density was measured using a black-and-white transmission densitometer DM-520 (SCREEN Holdings Co., Ltd.). Polyvinyl acetate (KH20 manufactured by NIHON GOSEI KAKO Co., Ltd.) having a saponification degree of 80% and a plasticizer (glycerin) were mixed at a mass proportion of 70/30 so as to obtain an oxygen barrier layer coating solution. The oxygen barrier layer coating solution was applied onto the film laminate (I) using a bar coater so that a thickness of a coating film after being dried was 2.0 µm, and dried at 120°C for 5 minutes so as to obtain a film laminate (II). The photosensitive resin composition was disposed on a PET film support (E5000 manufactured by TOYOBO CO., LTD., thickness: 125 µm) coated with a copolymerized polyester-based adhesive, and the film laminate (II) was superposed on the photosensitive resin composition. These were laminated at 100°C using a heat pressing machine so as to obtain a flexographic printing plate precursor including a PET support, an adhesive layer, a photosensitive resin layer, an oxygen barrier layer, a heat-sensitive mask layer, and a cover film. A total thickness of the plate was 1.14 mm.

### Production of printing plate from flexographic printing plate precursor

The production of a printing plate from a flexographic printing plate precursor was performed in the following two patterns in which different images to be formed were used.

### Pattern 1

The printing plate precursor was subjected to back exposure from the PET support side for 10 seconds. Subsequently, the cover film was peeled off. This printing plate was wound around CDI4530 manufactured by ESCO Graphics, and the imaging was performed at a resolution of 4000 dpi. As to the image, a test chart having a normal solid-printed part (without microcell) and solid-printed parts to which each of microcells MG45, MG34, MG25, WSI and MC16 was applied respectively was used. An imaged pattern was produced by arranging the test chart with 10 increments between boost values of 50 to 170. The main exposure was performed using an LED built in CDI4530 at a luminance of 22 mW/cm² for 480 seconds. After that, the plate was detached from CDI, and development was performed for 8 minutes using a developing machine (Stuck System, 1% aqueous washing soap solution, 40°C) manufactured by A & V Co., Ltd., and water droplets on the plate surface were removed with a drain stick. Thereafter, the plate was dried in a dryer at 60°C for 10 minutes, subjected to finishing exposure for 7 minutes, and finally irradiated with light from a germicidal lamp for 5 minutes, whereby a flexographic printing plate was thus obtained. The back exposure and finishing exposure were performed using TL-K 40W/10R lamp (peak wavelength: 370 nm, luminance at 350 nm: 10 mW/cm²) manufactured by Philips. As to the germicidal lamp, a germicidal lamp GL-40 (peak wavelength: 250 nm, luminance at 250 nm: 4.5 mW/cm²) manufactured by Panasonic Corporation was used. It was confirmed that the relief depth of the resultant printing plate was 0.6 mm.

### Pattern 2

The printing plate precursor was subjected to back exposure from the PET support side for 10 seconds. Subsequently, the cover film was peeled off. This plate was wound around CDI4530 (manufactured by ESCO Graphics), and was then subjected to abrasion at a resolution of 4000dpi using a test image having dots (at 175 lpi, 0 to 10%, in 0.3% increment), isolated dots (between 0 to 300 µm, in 50 µm increment), and dot gradation parts (fade-out parts) where the dot gradation shifts to zero. After the ablation, the plate was taken out, returned to the plane shape, and subjected to main exposure for 7 minutes. Thereafter, development was performed for 8 minutes using a developing machine (Stuck System, 1% aqueous washing soap solution, 40°C) manufactured by A & V Co., Ltd., and water droplets on the plate surface were removed with a drain stick. Thereafter, the plate was dried in a dryer at 60°C for 10 minutes, subjected to finishing exposure for 7 minutes, and finally irradiated with light from a germicidal lamp for 5 minutes, whereby a flexographic printing plate was thus obtained. The back exposure, main exposure and finishing exposure were performed using TL-K 40W/10R lamp (peak wavelength: 370 nm, luminance at 350 nm: 10 mW/cm²) manufactured by Philips. As to the germicidal lamp, a germicidal lamp GL-40 (peak wavelength: 250 nm, luminance at 250 nm: 4.5 mW/cm²) manufactured by Panasonic Corporation was used. It was confirmed that the relief depth of the resultant printing plate was 0.6 mm and dots each having a diameter of 16 µm were reproduced on the printing plate.

### Examples 2 to 12 and Comparative Examples 1 to 5

Flexographic printing plate precursors were prepared in the same manner as in Example 1 except that the composition ratio of each component in the photosensitive resin composition constituting the photosensitive resin layer was changed as presented in Tables 1 and 2. The time of back exposure was adjusted so that the relief depth became 0.6 mm.

### Comparative Example 6

A flexographic printing plate precursor was produced in the same manner as in Example 1, except that an oxygen barrier layer was not formed in the production of the flexographic printing plate precursor. Subsequently, in the production of a printing plate from the flexographic printing plate precursor, Membrane100 was laminated as an oxygen barrier layer on the heat-sensitive mask layer that had been subjected to imaging, by using a dedicated laminator. After the main exposure, Membrane100 was removed. Then, a flexographic printing plate was produced in the same manner as in Example 1.

Evaluation results of Examples 1 to 12 and Comparative Examples 1 to 6 are shown in Tables 1 and 2.

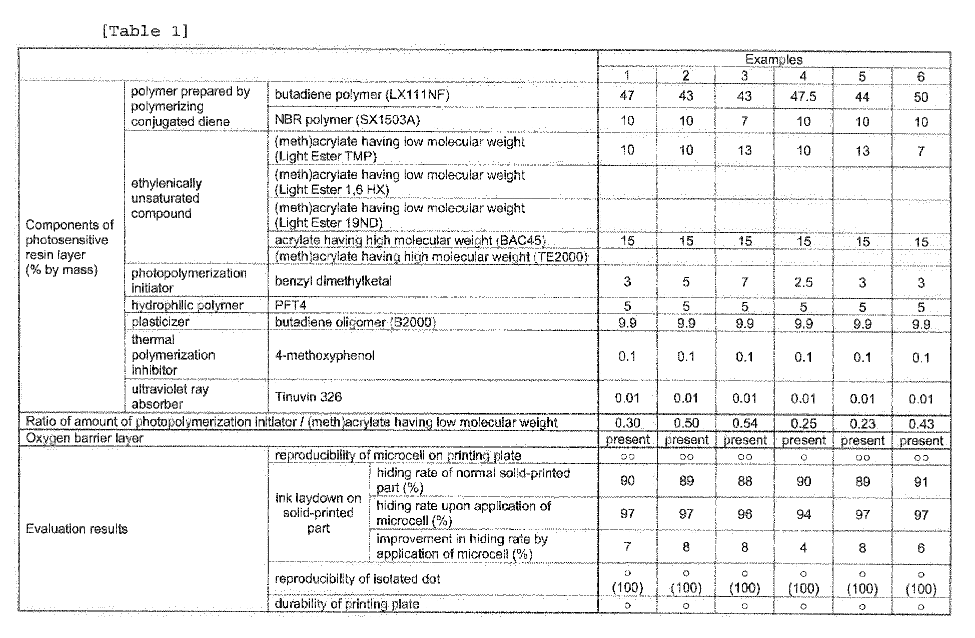

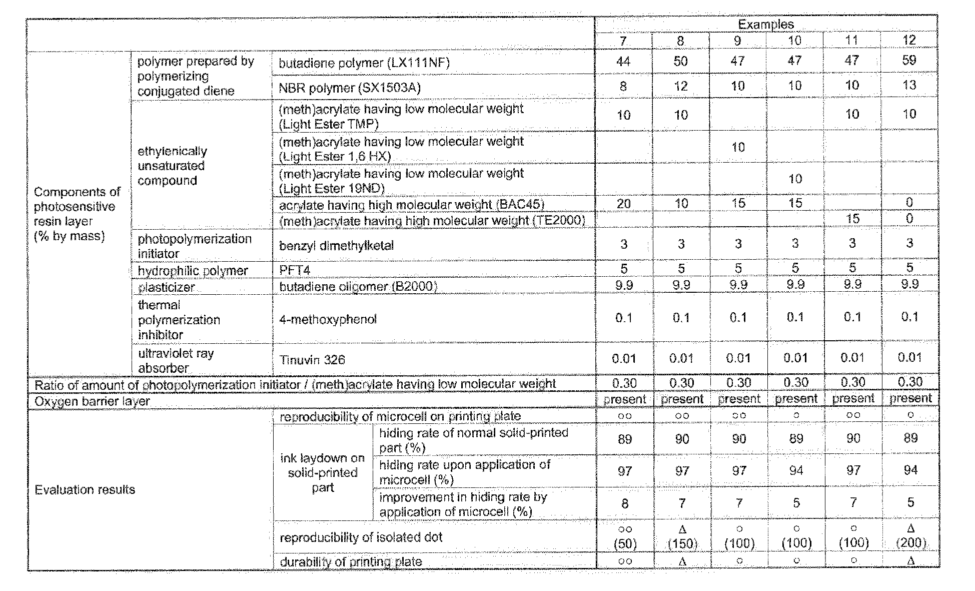

**[Table 2]**

| | | | | Comparative Examples | | | | | |
|---|---|---|---|---|---|---|---|---|---|
| | | | | 1 | 2 | 3 | 4 | 5 | 6 |
| Components of photosensitive resin layer (% by mass) | polymer prepared by polymerizing conjugated diene | butadiene polymer (LX111NF) | | 49 | 50.5 | 53.5 | 41 | 47 | 47 |
| | | NBR polymer (SX1503A) | | 10 | 12 | 12 | 9 | 10 | 10 |
| | ethylenically unsaturated compound | (meth)acrylate having low molecular weight (Light Ester TMP) | | 10 | 6 | 3 | 10 | 10 | 10 |
| | | (meth)acrylate having low molecular weight (Light Ester 1,6 HX) | | | | | | | |
| | | (meth)acrylate having low molecular weight (Light Ester 19ND) | | | | | | | |
| | | acrylate having high molecular weight (BAC45) | | 15 | 15 | 15 | 15 | 15 | 15 |
| | | (meth)acrylate having high molecular weight (TE2000) | | | | | | | |
| | photopolymerization initiator | benzyl dimethylketal | | 1 | 1.5 | 1.5 | 10 | 3 | 3 |
| | hydrophilic polymer | PFT4 | | 5 | 5 | 5 | 5 | 5 | 5 |
| | plasticizer | butadiene oligomer (B2000) | | 9.9 | 9.9 | 9.9 | 9.9 | 9.9 | 9.9 |
| | thermal polymerization inhibitor | 4-methoxyphenol | | 0.1 | 0.1 | 0.1 | 0.1 | 0.1 | 0.1 |
| | ultraviolet ray absorber | Tinuvin 326 | | 0.01 | 0.01 | 0.01 | 0.01 | 0.01 | 0.01 |
| Ratio of amount of photopolymerization initiator / (meth)acrylate having low molecular weight | | | | 0.10 | 0.25 | 0.50 | 1.00 | 0.30 | 0.30 |
| Oxygen barrier layer | | | | present | present | present | present | absent | - |
| Evaluation results | | reproducibility of microcell on printing plate | | × | Δ | × | ∘ | × | ∘∘ |
| | | ink laydown on solid-printed part | hiding rate of normal solid-printed part (%) | 90 | 90 | 91 | 84 | 88 | 90 |
| | | | hiding rate upon application of microcell (%) | 90 | 91 | 91 | 89 | 88 | 97 |
| | | | improvement in hiding rate by application of microcell (%) | 0 | 1 | 0 | 5 | 0 | 7 |
| | | reproducibility of isolated dot | | ∘ (100) | ∘ (100) | ∘ (100) | × (300) | ∘ (100) | ∘ (100) |
| | | durability of printing plate | | ∘ | ∘ | ∘ | × | ∘ | ∘ |

Details of the ethylenically unsaturated compound in the above Tables are as follows.
Light Ester TMP: Trimethylolpropane tri(meth)acrylate, number average molecular weight: 338, manufactured by Kyoeisha Chemical Co., Ltd.
Light Ester 1,6 HX: 1,6-hexanediol dimethacrylate, number average molecular weight: 254, manufactured by Kyoeisha Chemical Co., Ltd.
Light Ester 19ND: 1,9-nonanediol di(meth)acrylate, number average molecular weight: 298, manufactured by Kyoeisha Chemical Co., Ltd.
BAC45: Polybutadiene-terminal acrylate, number average molecular weight: 10000, manufactured by Osaka Organic Chemical Industry Ltd.
TE2000: Polybutadiene having a methacrylate group introduced at terminal thereof, urethane-bonded type, number average molecular weight: 3,000, manufactured by Nippon Soda Co., Ltd.

As apparent from the evaluation results shown in the table, in Examples 1 to 12 in each of which the amount of a photopolymerization initiator, the amount of a (meth)acrylate compound having a low molecular weight, and the blend ratio of the photopolymerization initiator to the (meth)acrylate compound having a low molecular weight are within the ranges defined in the present invention, the reproducibility of a microcell on a printing plate and the ink laydown performance in a solid-printed part were excellent. In addition, by further adding a (meth)acrylate compound having a high molecular weight, even when the photopolymerization initiator is added in a larger amount, the reproducibility of isolated dots and the durability of a printing plate are not deteriorated (see the comparison between Examples 1 to 6, and 9 to 11 with Examples 7, 8, and 12) .

In contrast, in Comparative Example 1, because the amount of the photopolymerization initiator added was small which was the same amount level as that employed conventionally, the reproducibility of a microcell on a printing plate and the ink laydown performance in a solid-printed part were inferior. In Comparative Example 2, because the amount of the photopolymerization initiator added was small, even when the ratio of the amount of the photopolymerization initiator to the amount of the (meth)acrylate compound having a low molecular weight was proper, the reproducibility of a microcell on a printing plate and the ink laydown performance in a solid-printed part were inferior. In Comparative Example 3, because the amount of the photopolymerization initiator added was small and the amount of the (meth)acrylate compound having a low molecular weight added was small, the reproducibility of a microcell on a printing plate and the ink laydown performance in a solid-printed part were inferior. In Comparative Example 4, because the amount of the photopolymerization initiator added was too large, the plate hardness in the solid-printed part was too high, whereby the ink laydown on the solid-printed parts was deteriorated. In addition, reproducibility of isolated dots and durability during printing were inferior. In Comparative Example 5, any oxygen barrier layer was not provided. Therefore, even though the amount of the photopolymerization initiator added, the amount of the (meth)acrylate compound having a low molecular weight, and the ratio of the amount of the photopolymerization initiator to the amount of the (meth)acrylate compound having a low molecular weight were proper, the reproducibility of a microcell on a printing plate and the ink laydown performance in a solid-printed part were inferior. In Comparative Example 6, the reproducibility of a microcell on a printing plate and the ink laydown performance on a solid-printed part were excellent. However, in Comparative Example 6, an oxygen barrier layer was laminated onto a heat-sensitive mask layer after the imaging instead of being formed between a photosensitive resin layer and a heat-sensitive mask layer. Therefore, a dedicated laminate was required for the lamination of the oxygen barrier layer, and the printing plate production process was complicated.

### Industrial Applicability

In the flexographic printing plate precursor according to the present invention, an oxygen barrier layer is provided between a photosensitive resin layer and a heat-sensitive mask layer and the content of a photopolymerization initiator in the photosensitive resin composition is increased compared with the conventional flexographic printing plate precursor. Therefore, a microcell pattern can be reproduced precisely on the surface of a printing plate without requiring the use of any specialized device or any additional step and without being affected by the oxygen-induced polymerization inhibition during exposure, particularly main exposure. As a result, the ink laydown on a solid-printed part in the printing plate can be improved. Therefore, the flexographic printing plate precursor according to the present invention is very useful in the industrial field.

## Claims

1. A flexographic printing plate precursor comprising at least a support (A), a photosensitive resin layer (B), an oxygen barrier layer (C) and a heat-sensitive mask layer (D) which are laminated in this order, wherein a photosensitive resin composition constituting the photosensitive resin layer (B) comprises (a) a polymer prepared by polymerizing a conjugated diene, (b) an ethylenically unsaturated compound and (c) a photopolymerization initiator, and wherein the content of the photopolymerization initiator (c) in the photosensitive resin composition is 2 to 9% by mass.

2. The flexographic printing plate precursor according to claim 1, wherein the ethylenically unsaturated compound (b) includes a (meth)acrylate compound (i) having a number average molecular weight of 100 to 600, wherein the content of the (meth)acrylate compound (i) having a number average molecular weight of 100 to 600 in the photosensitive resin composition is 5 to 16% by mass, and wherein the ratio of the mass of the photopolymerization initiator (c) to the mass of the (meth)acrylate compound (i) having a number average molecular weight of 100 to 600 in the photosensitive resin composition is within the range of 0.20 to 0.55.

3. The flexographic printing plate precursor according to claim 2, wherein the ethylenically unsaturated compound (b) further includes a (meth)acrylate compound (ii) having a number average molecular weight of more than 600 and not more than 20,000, and wherein the content of the (meth)acrylate compound (ii) having a number average molecular weight of more than 600 and not more than 20,000 in the photosensitive resin composition is 5 to 25% by mass.

4. The flexographic printing plate precursor according to any of claims 1 to 3, wherein the development is performed by using a water-based developing solution.

5. A flexographic printing plate obtained by exposing and developing the flexographic printing plate precursor of any of claims 1 to 4, **characterized in that** a microcell is applied to a solid-printed part formed on the printing plate.

6. A flexographic printing method, **characterized in that** the method uses the flexographic printing plate according to claim 5.
